# EUROPEAN PATENT APPLICATION

(11) **EP 1 022 767 A1**
(43) Date of publication of application: **26.07.2000**
(21) Application number: 00810055.4
(22) Date of filing: 21.01.2000
(51) Int. Cl.: H01L 21/00

(54) **Method for mounting semiconductor chips**

(30) Priority: 21.01.1999 CH 11699
(71) Applicant: Esec SA, 6330 Cham (CH)
(72) Inventor: Marty, Felix, 8832 Wollerau (CH)
(74) Representative: Falk, Urs, Dr.

(57) **Abstract**

When mounting semiconductor chips (3), the semiconductor chips are presented on a carrier foil (2). Unusable semiconductor chips are not marked with ink but data concerning the usability of the semiconductor chips and eventual further data concerning their quality are stored in a database known as a wafermap. When, on the carrier foil, the distance between the next semiconductor chip to be mounted (3b) and the last semiconductor chip mounted (3b) exceeds a predetermined value, the automatic assembly equipment approaches at least one intermediate position and determines its actual position based on the position of the sawing tracks (4) left in the carrier foil during sawing. If the determined actual position deviates from the set position, the difference is taken into consideration on approaching the next intermediate position or the next semiconductor chip.

## Description

The invention concerns a method for mounting semiconductor chips.

After manufacture, the semiconductor chips located on a wafer are tested. Afterwards, the wafer is adhered to a carrier foil and sawn so that the semiconductor chips can be mounted individually. It is known to save the results of the test in a database as a so-called wafermap. This, on the one hand, eliminates the inking of the unusable semiconductor chips which reduces the cycle time when testing. The cycle time for assembly is also reduced as the assembly equipment no longer has to check each semiconductor chip first to establish whether or not it is inked. The assembly equipment can directly process the usable semiconductor chips. On the other hand, additional data can be saved which give information concerning special characteristics of the semiconductor chips which can be taken into consideration later during assembly. Here it can then happen that the carrier foil with the sawn wafer is repeatedly fed to and removed from the assembly equipment whereby in each case those semiconductor chips are processed which fulfill predetermined criteria. The disadvantage is however that the additional stress on the carrier foil often leads to deformations of the carrier foil which are so large that with the known assembly equipment the correct assignment of the semiconductor chips on the carrier foil to the data in the wafer map is suddenly lost.

The object of the invention is to find a solution for the above mentioned problem.

With the method in accordance with the invention, each time the distance on the carrier foil between the next semiconductor chip to be mounted and the last semiconductor mounted exceeds a predetermined value, at least one intermediate position is approached and its actual position determined based on the location of the saw tracks left in the carrier foil during sawing. If the actual position deviates from the set position, ie its ideal position, the difference is also taken into consideration when approaching the next intermediate position or the next semiconductor chip.

In the following, embodiments of the invention are described in more detail based on the drawing.

It is shown in:
- Fig. 1: a carrier foil with semiconductor chips,
- Fig. 2: a partial section of the carrier foil, and
- Fig. 3: displacement vectors.

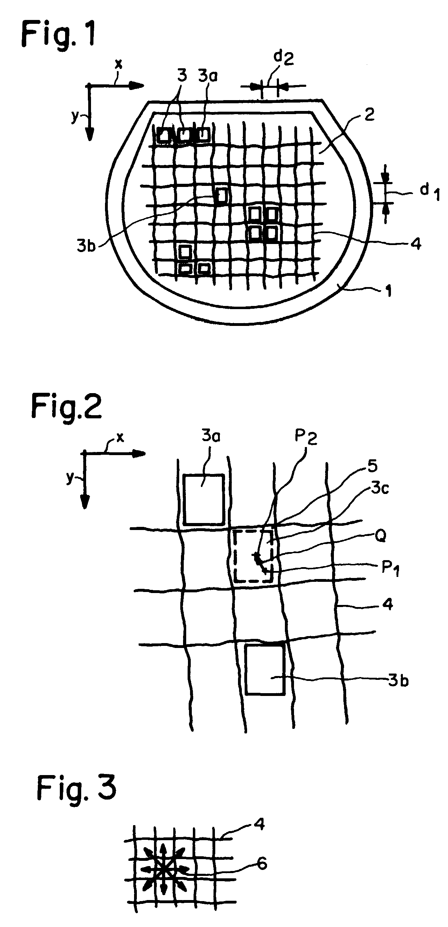

Fig. 1 shows a plan view of a carrier foil 2 clamped in a frame 1 on which semiconductor chips 3 adhere in rows and columns. The semiconductor chips 3 which were originally arranged next to each other on a wafer have been separated from each other by means of a saw whereby the saw left sawing tracks 4 on the carrier foil 2. The semiconductor chips 3 were measured by a test device before sawing whereby the measuring results were saved in a database. For each semiconductor chip 3 the data stored in the database contains at least the information as to whether the semiconductor chip 3 is usable or defective and therefore unusable. The data can also contain further information, for example the amplification factor for transistors, the maximum cycle time for microprocessors, etc. A database of this kind is generally called a wafermap.

The mounting of the semiconductor chips 3 onto a substrate takes place by means of a so-called Die Bonder. The Die Bonder has access to the database in which the data for the wafer to be processed are stored. With the example presented in Fig. 1, some of the semiconductor chips 3 have already been removed at an earlier point in time and the carrier foil 2 is now reloaded into the Die Bonder in order to mount the remaining usable semiconductor chips 3. It can therefore happen that, after mounting the semiconductor chip marked with 3a, the Die Bonder has to mount a semiconductor chip 3b which is not adjacent to the semiconductor chip 3a: A zone free of semiconductor chips is located between the two semiconductor chips 3a and 3b. The way in which the Die Bonder can reliably mount the semiconductor chip 3b will now be described based on the following embodiments.

With the first embodiment, a bondhead of the Die Bonder picks the semiconductor chip 3 at a fixed location A. The frame with the carrier foil 2 is thereby transported in X and/or in Y direction by means of a wafer table movable in the horizontal XY plane in order to provide the next semiconductor chip 3 to be processed at the location A whereby the X and Y direction are approximately parallel to the columns or rows in which the semiconductor chips 3 are arranged. A fixed camera is located above the location A which measures the position and orientation of the semiconductor chip 3 presented at location A in relation to a reference point with high accuracy. In the selected example, the semiconductor chip 3b is located in a column adjacent to the semiconductor chip 3a. However, the two semiconductor chips 3a and 3b are several rows away from each other. After the bondhead has picked the semiconductor chip 3a, the wafer table is moved to the next row, therefore by a distance d₁ in Y direction, and to the next column, therefore a distance d₂ in X direction, into an intermediate position whereby the distances d₁ and d₂ indicate the expected distance between adjacent semiconductor chips 3 in Y direction or in X direction. Now there is no semiconductor chip 3 located at the location A. Fig. 2 shows an enlarged part of the carrier foil 2. Because the carrier foil 2 is deformed, the reference point of the camera does not fall at point P₂ which marks the centre of the already processed and therefore missing semiconductor chip, but at a point P₁. The position of the wafer table in relation to the reference point is now determined in that, by means of the camera, the positions of the sawing tracks 4 are acquired and analysed instead of the position of the no longer available semiconductor chip 3c (the original position of the semiconductor chip 3c is indicated by a broken line). The sawing tracks 4 border an almost rectangular shaped area 5, within which both points P₁ and P₂ are located. An approximated value for the position of point P₂ is estimated based on the position of the sawing tracks 4 and from this a correction vector Q with coordinates q_{y} and qₓ is determined which points from point P₁ to the estimated value for the point P₂. Because no semiconductor chip is present at the intermediate position, its original position can only be approximately determined, ie, its original position or the position of the point P₂ belonging to it must be estimated based on the measured position of the sawing tracks 4 surrounding the point P₂. The correction vector Q therefore indicates how far the actual position of the wafer table is away from its set position at which it should present the not available semiconductor chip 3c, provided that this would be present, at the location A. With the next movement, the wafer table is shifted by the distance d₁ + q_{y} corrected by the correction vector Q in Y direction to the next row and by the distance qₓ in X direction within the same column. This process is repeated until the semiconductor chip 3b is present at the location A and can be mounted.

With this embodiment, "determining the actual position of the approached intemediate position" is therefore equivalent to "determining the actual position of the wafer table in the approached intermediate position".

The determination of the estimated value for the point P₂ based on the sawing tracks determined by the camera takes place with customary image processing technology and is here not explained further.

The method in accordance with the invention is therefore characterised in that the vector by which the wafer table must be displaced in order that after the semiconductor chip 3a the semiconductor chip 3b can be presented for mounting is broken down into smaller displacement vectors 6. Such a displacement vector 6 corresponds to the movement of the wafer table into the adjacent column and/or adjacent row. The eight possible displacement vectors 6 are drawn in Fig. 3. The method is further characterised in that after each movement of the wafer table by a displacement vector 6 into the adjacent column and/or row, a correction vector is determined and taken into consideration for the next movement of the wafer table. The correction vector contains the information by which distance in X direction and by which distance in Y direction the wafer table is incorrectly positioned because of eventual deformations of the carrier foil 2. With this method, it is ensured that the wafer table moves from column to column and/or row to row without unintentionally skipping a column or row.

Furthermore, it is possible to modify the values d₁ and/or d₂ under consideration of the correction vector determined with the previous movement or under consideration of several correction vectors determined with several previous movements. It is even possible to add data to the data stored in the database with information as to how large the distances d₁ and d₂ really are locally. Then, when a partially processed wafer is removed and later re-inserted for the processing of further semiconductor chips, the Die Bonder can go back to this data and take it into consideration for the calculation of the respective displacement vector.

With a second embodiment, the wafer table is only moved in X direction while the bondhead is moved more or less in Y direction corresponding to the Y position of the semiconductor chip 3 to be processed. The above method can be similarly transferred in that the wafer table is moved in X direction and the bondhead is moved in Y direction column for column and/or row for row and whereby a correction vector is determined after each movement which is taken into consideration for the next movement.

With this embodiment, "determining the actual position of the approached intermediate position" is equivalent to "determining the actual position of the wafer table regarding the X direction and determining the actual position of the bondhead regarding the Y direction".

For the invention it is irrelevant whether the wafer table and/or the bondhead are moved in X and Y direction for the processing of the semiconductor chip: It is only a matter of the relative movement. The invention can therefore also be used by automatic assembly equipment with which the wafer table remains stationary and only the bondbead moves in X and in Y direction.

The smaller the dimensions of the semiconductor chips 3, the greater is the effect of deformations of the carrier foil 2. While with very small semiconductor chips 3 it is practically unavoidable with the first embodiment to move the wafer table step-by-step from column to column and/or row to row and to measure the actual position at each intermediate position, with larger semiconductor chips 3 it is possible to move the wafer table each time by several, for example by two or three columns and/or rows. Conditional is that the point P₁ is still located within the area 5 bordered by the sawing tracks which belongs to point P₂. In other words, the error in the positioning of the wafer table caused by the deformation of the carrier foil 2 may only amount to just less than the half of the distances d₁ or d₂ in Y direction as well as in X direction.

With the method in accordance with the invention, the semiconductor chips are reliably presented at location A where they are to be picked by the bondhead.

In the event that an unprocessed chip which is stored in the database for example as defective or as not fulfilling the current conditions for processing, is still located between the last semiconductor chip 3a processed and the next semiconductor chip 3b to be processed, then it is advantageous to approach this unprocessed semiconductor chip on the way from semiconductor chip 3a to semiconducter chip 3b, to measure its position with the camera and to determine the correction vector Q which denotes the deviation of the actual position of the semiconductoer chip from its set position and to take this correction vector into consideration for the next movement.

## Claims

1. Method for mounting semiconductor chips (3), where the semiconductor chips (3) are presented on a carrier foil (2) and where data concerning the semiconductor chips (3) are stored in a database, **characterized in that**, when on the carrier foil (2) the distance between the next semiconductor chip to be mounted (3b) and the last mounted semiconductor chip (3a) exceeds a predetermined value, at least one intermediate position is approached, that its actual position is determined or estimated, that a correction vector is determined which corresponds to the deviation of the determined actual position from the set position and that the correction vector is taken into consideration on approaching a next intermediate position or the next semiconductor chip (3b).

2. Method according to claim 1, **characterized in that** at least one intermediate position is approached at which no semiconductor chip is located and that the actual position of the intermediate position is determined based on the position of the sawing tracks (4) left in the carrier foil (2) during sawing.

3. Method according to claim 1 or 2, **characterized in that** additional data is stored in the database which contains information about how large the local difference of the determined actual position to the set position is.
